# EUROPÄISCHE PATENTSCHRIFT

(11) **EP 2 024 991 B1**
(45) Veröffentlichungstag und Bekanntmachung des Hinweises auf die Patenterteilung: **17.10.2012**
(21) Anmeldenummer: 06776716.0
(22) Anmeldetag: 09.08.2006
(51) Int. Cl.: H01L 21/205, C30B 25/14, C30B 29/40, H01L 21/20

(54) **VERFAHREN ZUR HERSTELLUNG EINES DOTIERTEN III-N-KRISTALLS**
METHOD FOR PRODUCING A DOPED III-N CRYSTAL
PROCÉDÉS DE FABRICATION D'UN CRISTAL III-N DOPÉ

(43) Veröffentlichungstag der Anmeldung: 18.02.2009
(73) Patentinhaber: Freiberger Compound Materials GmbH, 09599 Freiberg (DE)
(72) Erfinder: SCHOLZ, Ferdinand, 89075 Ulm (DE); BRÜCKNER, Peter, 88069 Tettnang (DE); HABEL, Frank, 09599 Freiberg (DE); LEIBIGER, Gunnar, 09599 Freiberg (DE)
(74) Vertreter: Prüfer & Partner GbR European Patent Attorneys
(86) Internationale Anmeldenummer: PCT/EP2006/007894
(87) Internationale Veröffentlichungsnummer: WO 2008/017320

(56) Entgegenhaltungen:
- EP-A- 1 271 627
- EP-A2- 1 184 489
- WO-A-00/70129
- WO-A-01/68955
- WO-A-97/31140
- WO-A2-03/035945
- US-A- 5 902 393
- US-A1- 2002 170 484
- HUANG Y ET AL: "Spatial characterization of a 2 in GaN wafer by Raman spectroscopy and capacitance-voltage measurements" JOURNAL OF PHYSICS D (APPLIED PHYSICS) IOP PUBLISHING UK, Bd. 37, Nr. 20, 21. Oktober 2004 (2004-10-21), Seiten 2814-2818, XP002418317 ISSN: 0022-3727
- DATABASE INSPEC [Online] THE INSTITUTION OF ELECTRICAL ENGINEERS, STEVENAGE, GB; Juni 2002 (2002-06), CHALDYSHEV V V ET AL: "Micro-Raman investigation of the n-dopant distribution in lateral epitaxial overgrown GaN/sapphire (0001)" XP002421203 Database accession no. 7416725 & Journal of Electronic Materials TMS; IEEE USA, Bd. 31, Nr. 6, Juni 2002 (2002-06), Seiten 631-634, ISSN: 0361-5235
- T. L. CHU ET AL: 'Crystal Growth and Characterization of Gallium Nitride' JOURNAL OF ELECTROCHEMICAL SOCIETY Bd. 121, 01 Januar 1974, Seiten 159 - 162, XP055003220

## Beschreibung

### Hintergrund der Erfindung

Die vorliegende Erfindung bezieht sich auf ein Verfahren zur Herstellung von dotierten III-N-Massivkristallen aus der Gasphase, sowie auf ein Verfahren zur Herstellung von freistehenden dotierten III-N-Substraten, die aus den dotierten III-N- Massivkristallen gewonnenen werden. Dabei bedeutet N Stickstoff und III mindestens ein Element der III. Hauptgruppe des Periodensystems, ausgewählt aus Aluminium, Gallium und Indium (im folgenden teilweise abgekürzt mit (Al, Ga, In)). Die aus dem Verfahren erhaltenen, freistehenden dotierten III-N-Substrate sind als Substrate zur Fertigung von optischen und optoelektronischen Bauelementen sehr gut geeignet.

Herkömmlich sind in der gewerblichen Anwendung Bauelemente für (Al,Ga,In)N-basierende Leucht- oder Laserdioden im wesentlichen auf Fremdsubstraten wie Al₂O₃ (Saphir) oder SiC gezüchtet worden.

Die durch Verwendung der Fremdsubstrate entstehenden Nachteile bezüglich der Kristallqualität und folglich der Bauelementlebensdauer und -effizienz kann man durch Wachstum auf freistehenden III-N-, wie z.B. (Al,Ga)N-Substraten begegnen. Letztere sind jedoch in ausreichender Qualität bisher kaum verfügbar. Die Ursache dafür sind im wesentlichen Schwierigkeiten bei konventionellen Massivzüchtungstechnologien auf Grund des extrem hohen Gleichgewichtsdampfdrucks von Stickstoff über III-N-Verbindungen bei typischen Wachstumstemperaturen.

Die Züchtung von Massivmaterial unter hohem Druck wurde von Porowski beschrieben (MRS internet J. Nitride Semicond. Res 451, 1999, G1.3). Dieses Verfahren liefert qualitativ hochwertiges GaN-Massivmaterial, hat jedoch den Nachteil, dass damit bislang nur kleine GaN-Substrate mit einer Fläche von maximal 100 mm² hergestellt werden können. Zudem benötigt das Herstellungsverfahren im Vergleich zu anderen Verfahren viel Zeit und ist aufgrund der extrem hohen Wachstumsdrücke technologisch aufwendig.

Eine weitere Methode ist die Züchtung von III-N-Material auf Fremdsubstrat aus der Gasphase mit anschließender Abtrennung vom Fremdsubstrat.

Zur Herstellung von dicken freistehenden Schichten aus III-N wie GaN ist z.B. aus der Veröffentlichung "Large Free-Standing GaN Substrates by Hydride Vapor Phase Epitaxy and Laser-Induced Liftoff" von Michael Kelly et al. (Jpn. J. Appl. Phys. Vol 38, 1999, S. L217-L219) bekannt, eine zunächst auf einem Substrat aus Saphir (Al₂O₃) mittels Hydridgasphasenepitaxie (HVPE) gewachsene dicke GaN-Schicht von dem Saphirsubstrat abzulösen. Dazu wird beschrieben, die mit GaN beschichteten Saphirsubstrate mit einem Laser zu bestrahlen, wodurch die GaN-Schicht an der Grenzfläche zum Saphirsubstrat lokal thermisch zersetzt wird und sich dadurch von dem Saphirsubstrat ablöst. Alternative Ablösemethoden sind nasschemisches Ätzen (beispielsweise von GaAs; K. Motoki et al., Jap. J. Appl. Phys. Vol. 40, 2001, S. L140-L143), trockenchemisches Ätzen (beispielsweise von SiC; Yu. Melnik et al., Mat. Res. Soc. Symp. Proc. Vol. 482, 1998, S. 269-274) oder mechanisches Abläppen (beispielsweise von Saphir; H.-M. Kim et al., Mat. Res. Soc. Symp. Proc. Vol. 639, 2001, S. G6.51.1-G6.51.6) des Substrates.

Der Nachteil der beschriebenen Methoden liegt zum einen in den relativ hohen Kosten auf Grund der aufwendigen Technologien zur Substratablösung und zum anderen in der prinzipiellen Schwierigkeit, III-N-Material mit einer homogenen niedrigen Defektdichte herzustellen.

Eine Alternative zu den genannten Verfahren bietet die Züchtung von dicken III-N-Massivkristallen (Boules) auf III-N-Substrat mittels Gasphasenepitaxie bei anschließender Vereinzelung des Massivkristalls durch ein Sägeverfahren.

Solch ein Verfahren wurde von Vaudo et al. (US 6,596,079) beschrieben. Als bevorzugte Züchtungsmethode wurde die HVPE gewählt; als bevorzugte Boule-Kristalllängen wurden Werte > 1 mm, 4 mm bzw. 10 mm angegeben. Vaudo et al. beschreiben u.a. weiterhin, wie man durch Drahtsägen bzw. weitere Bearbeitungsschritte, wie beispielsweise chemischmechanisches Polieren, reaktives Ionenstrahlätzen oder photoelektrochemisches Ätzen, III-N-Substrate aus dem Massivkristall erhält. In einer internationalen Patentanmeldung von Vaudo et al. (WO 01/68955 A1) werden darüberhinaus auch mittels der beschriebenen Technologie produzierte III-N-Massivkristalle und -Substrate erwähnt.

Melnik et al. beschreiben ein Verfahren zur Züchtung von GaN- (US 6,616,757) bzw. AlGaN-Massivkristallen ( US 2005 0212001 A1) mit Kristalllängen größer 1 cm. Dabei besteht das Verfahren aus den prinzipiellen Schritten: Wachsen einer einkristallinen (Al)GaN-Schicht auf einem Substrat, Entfernen des Substrates und Wachsen des (Al)GaN-Massivkristalls auf der einkristallinen (Al)GaN-Schicht. Als bevorzugte Methode wird ein HVPE-Verfahren mit einer speziellen Reaktorkonfiguration angegeben. Darüber hinaus beschreiben Melnik et al. in einer US-Anmeldung (US 2005 0164044 A1) bzw. in US 6,936,357 GaN- bzw. AlGaN-Massivkristalle mit verschiedenen Eigenschaften, wie beispielsweise Abmessungen, Versetzungsdichten oder Halbwertsbreiten von Röntgenbeugungskurven.

Neben der Kristallinität müssen auch die elektrischen Eigenschaften der Halbleiterkristalle auf die Bedürfnisse der jeweiligen Anwendung angepasst werden. Die Eigenschaften von Halbleiterkristallen, insbesondere die elektrischen Eigenschaften, lassen sich durch den Einbau von Fremdatomen, sogenannten Dotierstoffen steuern. Durch die Konzentration der Dotierstoffe in einem Kristall kann die Konzentration der Ladungsträger und damit der spezifische elektrische Widerstand gesteuert werden. Für optoelektronische Bauelemente werden leitende Substrate eingesetzt, um eine Kontaktierung des Bauelements über die Rückseite des Substrates zu ermöglichen. Im Falle von GaN- oder AlGaN-Substraten wird üblicherweise eine n-Dotierung, d.h. der Einbau von Fremdatomen, die bewegliche Elektronen liefern, gewählt. Gängiger Dotierstoff für (Al)GaN ist beispielsweise Silizium. Eine p-Dotierung, d.h. der Einbau von Fremdatomen, die Löcher, d.h. Defektelektonen liefern, ist ebenso möglich. Gängiger Dotierstoff für (Al)GaN ist beispielsweise Magnesium. Eine weitere Möglichkeit stellt der Einbau von Fremdatomen dar, welche als energetisch tiefe Störstellen wirken und somit bewegliche Ladungsträger binden und dadurch die Leitfähigkeit des Kristalls verringern. Dies ist bei (Al)GaN beispielsweise mit Eisen möglich.

In der Gasphasenepitaxie werden die Dotierstoffe üblicherweise in Form von gasförmigen Verbindungen bereitgestellt. Beispielsweise können für Silizium Silan SiH₄, für Magnesium Bis(Cyclopentadienyl)Magnesium Mg(C₅H₅)₂ und für Eisen Bis(Cyclopentadienyl)Eisen Fe(C₅H₅)₂ verwendet werden.

Manabe et al. (US-Pat. 6,472,690) beschreiben beispielsweise die n-Dotierung von GaN durch Zuleitung eines Silizium-haltigen Gases. Usikov et al. (Mat. Res. Soc. Proc. Vol. 743 L3.41.1) beschreiben die n-Dotierung bei der HVPE durch Zuleitung von Silan. Über die Homogenität wird keine Aussage gemacht.

Vaudo et al. (US-Pub. 2005/0009310A1) beschreiben semi-isolierende GaN-Kristalle mit einer Dotierung mit tiefen Akzeptoren. In der Beschreibung werden als Dotierstoffe Metallorganische Verbindungen genannt.

Für das HVPE-Wachstum können auch Chlor-haltige Verbindungen, wie beispielsweise Dichlorsilan SiCl2H2, verwendet werden. Usui et al. (JP3279528B) beschreiben die Dotierung mit SiHxCl(4-x).

Die Erzeugung der Chlorid-Verbindungen der Dotierstoffe kann beim HVPE-Verfahren analog der Erzeugung von GaCl in situ durch die Reaktion des elementaren Dotierstoffes mit HCl erfolgen. So können die gasförmigen Dotierstoffe über zusätzliche Gaslinien in Verbindung mit entsprechenden zusätzlichen Tiegeln mit den jeweiligen elementaren Ausgangsmaterialien im Reaktor erzeugt werden. Dieses Verfahren wird beispielsweise von Fomin et al. (phys. stat. sol. (a) vol. 188 pp. 433) beschrieben. Hong et al. (US-Pat. 6,177,292) erwähnen diese Vorgehensweise, um eine N-dotierte GaN-Schicht auf einem polierten GaN Substrat zu erzeugen. Nikolaev et al. (US-Pat. 6,555,452; entsprechend US 2002/28565 A) beschreiben die p-Dotierung durch die Einbringung eines metallischen Dotierstoffes wie Mg oder Zn in einen zusätzlichen, gegenüber dem III-Quellenmaterial getrennten Quellen-Bereich. Dieses Verfahren erfordert eine komplexe Erweiterung der Gaszuführungen und Quellen im Reaktor.

### Zusammenfassung der Erfindung

Der vorliegenden Erfindung liegt die Aufgabe zugrunde, ein Verfahren zur Herstellung von dotierten III-N-Kristallen und insbesondere von dotierten III-N-Massivkristallen mit guter Kristallqualität und homogener Verteilung der Dotierstoffe in Wachstumsrichtung und/oder in der Ebene senkrecht dazu bereitzustellen.

Die Aufgabe wird gelöst durch ein Verfahren gemäß Anspruch 1. Ein weiterer Gegenstand der Erfindung zum Herstellen eines freistehenden dotierten III-N-Kristallsubstrats ist in Anspruch 12 festgelegt. Bevorzugte Ausführungsformen sind in den Unteransprüchen in jeweils Anspruch 1 bzw. Anspruch 12 definiert.

Erfindungsgemäß kann ein überraschend homogener Einbau von Dotierstoffen in die kristalline III-N-Schicht oder in den III-N-Massivkristall erreicht werden. Die gemeinsame Mischzufuhr des mindestens einen Dotierstoffs mit dem mindestens einen III-Material erfolgt zweckmäßig über dieselbe Zuleitung. Beim HVPE-Verfahren erfolgt die Mischzufuhr so, daß der mindestens eine Dotierstoff und das mindestens eine III-Material aus derselben Quelle stammt und so gemeinsam in den Reaktor zugeführt wird. Der besonders homogene Einbau des Dotierstoffs in die kristalline III-N-Schicht oder in den III-N-Massivkristall wird insbesondere dadurch erreicht, dass der Dotierstoff direkt in die Wanne des Gruppe III-Materials gegeben wird. Ferner wird dieser besonders homogene Einbau dadurch erreicht, dass der mindestens eine Dotierstoff in elementarer Form und mit dem mindestens einen Gruppe III-Ausgangsmaterial in elementarer Form als Mischung vorgegeben werden. Die Mischung kann geeigneterweise als feste Lösung oder als gemeinsame Schmelze, insbesondere in Form einer Legierung, vorliegen. Erfindungsgemäβ wird dafür gesargt, daß Spezies des mindestens einen Dotierstoffs und des mindestens einen III-Materials auf vorteilhafte Weise gemeinsam in die Gasphase übergehen und dann dem Reaktor zugeführt werden.

Gemäß einer besonderen, bevorzugten Ausführungsform erfolgt das erfindungsgemäβe Verfahren so, dass in einem Reaktor für Hydridgasphasenepitaxie (HVPE) eine gemeinsame Quelle und/oder eine gemeinsame Zuleitung für ein Gruppe III-Ausgangsmaterial und ein Dotiermittel in den HVPE-Reaktor bereitgestellt wird und ein Halogenid-Reaktionsgas in die bzw. zu der gemeinsame(n) Quelle und/oder die bzw. der gemeinsame(n) Zuleitung so eingeführt wird, daß eine Mischung von Halogeniden des Gruppe III-Ausgangsmaterials und des Dotierstoffs gebildet wird und die Mischung einem Wachstumsbereich des HVPE-Reaktors zugeführt wird, und wobei ein N-Ausgangsmaterial in den HVPE-Reaktor eingeführt wird, wodurch die dotierte kristalline III-N-Schicht oder der dotierte III-N-Massivkristall mit einem homogenen Einbau des Dotierstoffs in den III-N-Kristall gebildet wird.

Gemäß einer weiteren besonderen bevorzugten Ausführungsform umfasst das erfindungsgemäβe Verfahren folgende Schritte : Bereitstellen einer festen Lösung, einer Legierung oder einer gemischten Schmelze, in der jeweils das Element der III. Hauptgruppe des Periodensystems und das Element des Dotierstoffs für das III-N-Material der kristallinen III-N-Schicht oder des dotierten III-N-Massivkristalls enthalten ist; Kontaktieren der bereitgestellten Legierung mit einem Reaktionsgas zur Bildung von gemischten Produkten aus dem Gruppe III-Element und dem Dotierstoff jeweils mit einem Bestandteil des Reaktionsgases in Gasphase; Kontaktieren der so gebildeten gemischten Produkte mit einem N-Ausgangsmaterial in Gasphase; und
Abscheidung von kristalliner III-N-Schicht oder von III-N-Massivkristall jeweils mit eingebautem Dotierstoff.

Das Reaktionsgas umfaßt typischerweise HCl und/oder ein anderes Chlorid, gegebenenfalls mit Trägergas vermischt, zur Bildung von gemischten Produkten, die Chloride des Gruppe III-Elements und des Dotierstoffs umfassen.

Bei dem erfindungsgemäßen Verfahren werden also nicht wie im oben aufgeführten Stand der Technik ein Dotierstoff und die Ausgangsmaterialien für das Kristallwachstum, insbesondere die Gruppe-III Komponente, welche für die Wachstumsrate stark beeinflusst, getrennt - typischerweise über getrennte Leitungen - zum Wachstumsbereich geführt. Vielmehr liegt bei der erfindungsgemäßen Verfahrensweise beim Eintritt in den Reaktor bereits eine Mischung mindestens des ausgewählten Dotierstoffs mit mindestens dem ausgewählten Gruppe III-Ausgangsmaterial vor. Am zweckmäßigsten teilen sich ein Dotierstoff und ein Gruppe III-Ausgangsmaterial, gegebenenfalls auch nur in Teilmengen von Dotierstoff und/oder Gruppe III-Ausgangsmaterial, mindestens eine Zufuhrleitung. Insbesondere liegen der mindestens eine Dotierstoff und das mindestens eine Gruppe III-Ausgangsmaterial gemeinsam in einem gemeinsamen Rohr für Quellmaterial vor, und noch weiter bevorzugt liegen beide gemeinsam in einer Quell-Wanne oder einem Quell-Behältnis, am besten als Mischung in jeweils elementarer Form, vor. Besonders vorteilhaft und daher bevorzugt ist es, wenn der mindestens eine Dotierstoff und das mindestens eine Gruppe-III-Ausgangsmaterial gemeinsam als feste gemischte Lösung oder als gemischte Schmelze, vor allem als Legierung vorgegeben werden. Durch die erfindungsgemäße Verfahrensweise können Bedingungen geschaffen werden, wonach die Konzentrationen des Gruppe-III-Quellmaterials und der Dotierstoffquelle auf der Wachstumsfläche gleich verteilt sind, und wonach überall an der Wachstumsfront zu einem bestimmten Zeitpunkt stets dasselbe Verhältnis von Gruppe-III-Material zu Dotierstoff herrscht. Lokale Schwankungen über die Wachstumsebene hinweg können vermieden werden. Folglich kann erfindungsgemäß eine sehr hohe Homogenität des Einbaus der Dotierstoffe erhalten werden. Dies steht im Gegensatz zu einer unterschiedlichen Verteilung bei einer Verfahrensweise gemäß Stand der Technik, wo das eigentliche Quellmaterial für das Wachstum und die Einbringung des Dotierstoffes getrennt und unabhängig voneinander erfolgen. Die unterschiedliche Verfahrensweise der Erfindung und des Stands der Technik wirkt sich um so mehr aus, je dicker die jeweils epitaxial gewachsenen Schichten sind. Während die Verfahren des Stands der Technik für die Erzeugung dünner dotierter Schichten noch akzeptabel sein könnten, eignen sie sich nicht zur homogenen Dotierung von dicken Kristallen. Erfindungsgemäß wird die sehr homogene Dotierung im Kristall noch bei relativ dicken III-N-Massivkristallen von mindestens 1 mm und sogar von mindestens 1 cm und besonders vorteilhaft von mindestens 3 cm erreicht werden. In diesem Sinne ist ein Abscheiden mittels Gasphasenepitaxie in einem Gasphasenepitaxie-Reaktor und vor allem die Anwendung der Hydridphasenepitaxie (HPVE) erfindungsgemäß besonders effektiv, weil damit eine zum Erreichen solcher dicker III-N-Massivkristalle eine vorteilhafte hohe Wachstumsrate von etwa 200 bis etwa 1000µm/h, vorzugsweise bis etwa 750µm/h gewählt werden kann und trotzdem ein gleichzeitig homogener Einbau von Dotierstoffen realisierbar ist. Darüber hinaus kann bei dem erfindungsgemäßen Verfahren der technische Aufwand im Vergleich zur herkömmlichen Technik vereinfacht werden, was wiederum die Steuerbarkeit der Dotierung erleichtert. Während im Stand der Technik für die Dotierstoffe separate Leitungen mit separater Steuerungs- und Regeltechnik (Ventile, Massenflussregler) vorzusehen sind, können erfindungsgemäß Steuerungs- und Regeltechnik für die Dotierstoffquelle und für das eigentliche III-Quellmaterial geteilt werden.

Aus WO 00/68470 ist ein Verfahren zum Herstellen einer p-Typ III-N Schicht mittels HVPE bekannt, bei dem Mg als p-Dotierstoff in Mischung mit dem III-Metall in die III-Quelle gegeben werden kann.

Die Erfindung und ihre besondere Aufgaben, Merkmale und Vorteile werden nachstehend anhand von bevorzugten Ausführungsformen, Zeichnungen und Beispielen näher beschrieben, die aber nur beispielhaft und keineswegs einschränkend zu verstehen sind.

Kurzbeschreibung der Zeichnungen

In den Figuren sind gezeigt:
Fig. 1 zeigt schematisch einen grundsätzlichen Aufbau einer HVPE-Anlage im Querschnitt, auf die die vorliegende Erfindung anwendbar ist.
Fig. 2 zeigt das Phasendiagramm der Legierung Gallium Silizium, das in einer Ausfiihrungsform der vorliegenden Erfindung genutzt werden kann.
Fig. 3 zeigt das Phasendiagramm der Legierung Gallium Magnesium, das in einer anderen Ausführungsform der vorliegenden Erfindung genutzt werden kann..
Fig. 4 zeigt das Phasendiagramm der Legierung Gallium Eisen, das in einer noch anderen Ausführungsform der vorliegenden Erfindung genutzt werden kann.
Fig. 5 zeigt schematisch einen grundsätzlichen Aufbau einer vertikalen HVPE-Anlage im Querschnitt, auf die die vorliegende Erfindung anwendbar ist.

### Beschreibung bevorzugter Ausführungsformen der Erfindung

Bei der HVPE wird das Gruppe-III Quellmaterial elementar im Reaktor vorgelegt. Bei erhöhter Temperatur, beispielsweise in einem Bereich von 800 bis 900°C, wird HCl über das flüssige Material geleitet, es reagiert zu einer Choridverbindung, die dann zum Wachstumsbereich geleitet wird. Die Dotierstoffe werden direkt in das Ausgangsmaterial gegeben und lösen sich dort zu einem bestimmten Anteil. Sobald HCl über die Quelle geleitet wird, bilden sich sowohl Chloridverbindungen des Gruppe-III-Materials als auch des Dotierstoffes. Diese werden dann in einem einstellbaren, bestimmten Verhältnis von Gruppe-III-Material zu Dotierstoff gemeinsam in einer Leitung zum Wachstumsbereich geführt und treffen auch gemeinsam auf die Kristalloberfläche. Der HCl-Fluss über die Schmelze regelt gleichzeitig die Wachstumsrate des Kristalls und die Dotierung. Damit liegt praktisch immer im wesentlichen dasselbe Verhältnis von Gruppe-III-Material und Dotierstoff vor. Die Dotierung im Kristall ist somit unabhängig von der Wachstumsrate und verläuft völlig homogen. Das Verhältnis von Gruppe-III-Material zu Dotierstoff hängt von der Dotierstoffkonzentration in der gemeinsamen Schmelze und von der unterschiedlichen Kinetik der Chloridbildung des jeweiligen Materials ab. Unterschiede in der Reaktionskinetik können zu einer unterschiedlichen Konzentration des Dotierstoffes in der Schmelze und im Gasstrom führen, für eine vorgegebene Konzentration in der Schmelze ist jedoch auch immer die Konzentration im Gasstrom konstant.

Als Einstellmöglichkeit kann dem Gruppe III-Quellmaterial ein Überangebot des Dotierstoffes, d.h. eine über der Löslichkeitsgrenze im Gruppe-III-Material liegende Menge des Dotierstoffs, zugegeben werden. Der Anteil in der Schmelze und somit die Dotierstoffkonzentration im Kristall kann ferner durch die Löslichkeitsgrenze des Dotierstoffs im Gruppe III-Material beeinflußt werden. Die maximale Löslichkeit ist temperaturabhängig, somit kann über diesen Mechanismus die Dotierung des Kristalls über die Temperatur der Schmelze eingestellt werden. Sofern der Dotierstoff eine geringere Dichte hat als das Gruppe-III-Quellmaterial, kann ein sich nicht in der III-Schmelze lösendes Überangebot des Dotierstoffs konstruktiv so in der Schmelze verankert werden, dass er nicht auf dem Gruppe III-Material aufschwimmt und direkt in Kontakt mit dem HCl-Gas kommt. Eine Verankerung läßt sich zum Beispiel durch ein in der Wanne befindliches Gitter realisieren, das in die Schmelze des Gruppe III-Materials eintaucht. Falls gewünscht könnte zur Vermischung des Gruppe III-Elements und des Dotierstoffs in der Schmelze eine mechanische Mischvorrichtung, z.B. ein Rührer oder ein Agitator, vorgesehen werden.

Gemäß einem weiteren Gegenstand der Erfindung wird die Dotierstoff-Konzentration des dotierten Kristalls über die Menge des in die Quelle gegebenen Dotierstoffes eingestellt.

Die maximale Konzentration ist physikalisch über die Löslichkeitsgrenze vorgegeben, die Dotierstoff-Konzentration kann jedoch durch Zugabe von geringeren Mengen des Dotierstoffes beliebig verringert werden. Mit dieser Methode kann die Dotierstoffkonzentration für einen ganzen Kristall einfach eingestellt werden.

Als weitere Einstellmöglichkeiten können gemischte Zugaben nicht nur aus einer gemeinsamen Quelle bzw. Zuleitung, sondern aus mehreren gemeinsamen Quellen erfolgen, oder es kann eine Kombination von (i) einer gemischten Zugaben aus einer gemeinsamen Quelle bzw. Zuleitung mit (ii-1) einer oder mehreren weiteren gemischten Zugaben aus einer gemeinsamen Quelle bzw. Zuleitung oder mit (ii-2) einer oder mehreren getrennten Zugaben des Gruppe III-Materials alleine und/oder des Dotierstoffs alleine durchgeführt werden.

Über die oben beschriebenen Einstellmöglichkeiten können homogen verteilte Dotierstoffmengen je nach Bedarf oder Wunsch über einen weiten bis engen Mengenbereich im dotierten III-N-Kristall variabel und flexibel eingestellt werden. Geeignet, jedoch keinesfalls einschränkend sind beispielsweise Konzentrationen im Bereich von 1x10¹⁶ bis 1x10² cm⁻³, und insbesondere 1x10¹⁷ bis 1x10¹⁹ cm⁻³ Dotierstoff im erhaltenen Kristall.

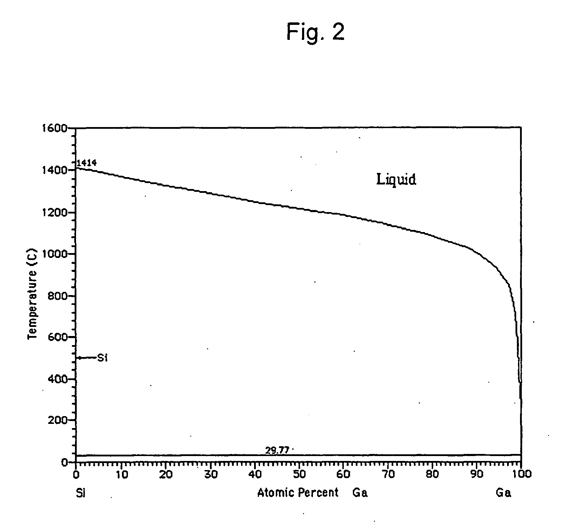

Als Beispiel ist in Fig. 2 das Löslichkeits-Diagramm von Silizium in Gallium dargestellt. Daraus ist ersichtlich, daß bei einer möglichen Betriebstemperatur zum Einströmen des Gruppe III-Materials, also bei z.B. ungefähr 850°C, die Löslichkeitsgrenze von Silizium in Gallium bei etwa 2% liegt. Das heißt, eine solche Mischung bzw. Legierung von bis zu maximal 2% Si als Dotierstoff in Ga als Gruppe III-Material ermöglicht ohne konstruktive Erweiterung des Reaktors eine homogene Dotierung der Kristalle und liefert damit ohne Zusatzaufwand bessere Ergebnisse.

Ferner ist aus Fig. 2 ersichtlich, daß bei einer anderen Temperatur, z.B. bei einer möglichen Betriebstemperatur zum Einströmen des Gruppe III-Materials von ungefähr 900°C, die Löslichkeitsgrenze von Silizium in Gallium bei etwa 3% liegt. Somit kann durch einfache Änderung der Betriebstemperatur das Verhältnis des Dotierstoffs Si zu dem Gruppe III-Material Ga und folglich das Verhältnis von Si zu Ga im III-N-Kristall geändert werden.

Bei Bedarf, z.B. wenn noch höhere Mengen eines Dotierstoffs erwünscht sind, kann noch ein zusätzlicher, getrennter Zustrom nur von Dotierstoff bewerkstelligt werden. Auch in einem solchen Fall wird die Homogenität des Dotierstoffeinbaus in den III-N-Massekristall wegen des mindestens teilweisen Mischzustroms von Dotierstoff und Gruppe III-Material insgesamt verbessert.

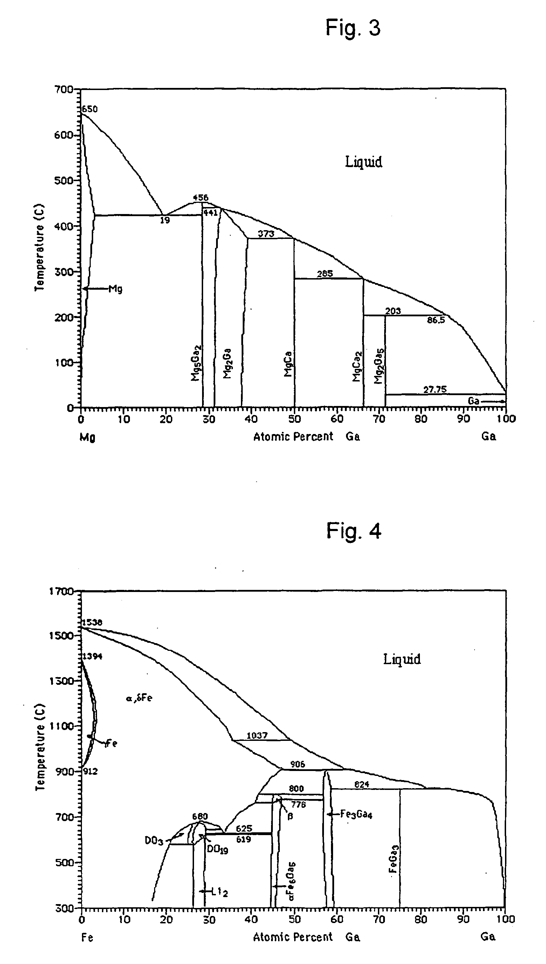

Fig. 3 zeigt das Phasendiagramm der Legierung Gallium-Magnesium. Bei 850°C kann jede beliebige Konzentration von Magnesium in Gallium gelöst werden.

Fig. 4 zeigt das Phasendiagramm der Legierung Gallium-Eisen. Bei 850°C liegt die Löslichkeitsgrenze von Eisen in Gallium bei etwa 18%. Je nach gewählter Temperatur kann die Löslichkeitsgrenze von Eisen in Gallium variabel einstellbar sein.

Phasendiagramme für andere, erfindungsgemäß nutzbare Mischungs- bzw. Legierungs-Systeme von Dotierstoff und Gruppe III-Material können aus entsprechenden physikalischen Nachschlagewerken entnommen werden.

Gemäß einem weiteren Gegenstand der Erfindung können zwei Quellen parallel betrieben werden. In einer Quelle wird ein Gruppe-III-Material ohne Dotierstoff vorgelegt, in einer weiteren Quelle wird vorzugsweise dasselbe Gruppe-III-Material, ggf. alternativ oder zusätzlich ein anderes Gruppe-III-Material, mit einer hohen Konzentration des gewünschten Dotierstoffs, gegebenenfalls im Bereich der Löslichkeitsgrenze, gemeinsam vorgelegt. Eine unterschiedliche Aufteilung des HCl-Flusses auf die beiden Quellen ermöglicht auf diese Weise eine Feinsteuerung und/oder falls gewünscht eine Änderung der eingebauten Dotierstofikonzentration. Die Gasströme aus beiden Quellen können anschließend über einen gemeinsamen Gaseinlass zum Wachstumsbereich geführt werden, um Inhomogenitäten weiter zu unterdrükken.

Eine weitere Variante besteht darin, daß eine weitere Zufuhr von einer zusätzlichen, getrennten Quelle von Dotierstoff allein oder in Mischung mit demselben oder einem anderen Gruppe III-Material durchgeführt wird.

Erfindungsgemäß können ein oder mehrere Dotierstoffspezies verwendet werden, und/oder es können ein oder mehrere Spezies des Gruppe III-Materials verwendet werden. Weder bezüglich der zu verwendenden Dotierstoffe noch bezüglich der zu verwendenden Gruppe III-Quellmaterialien gibt es Beschränkungen. Beispielsweise eignen sich als Dotierstoffe, allein oder in Kombination, ein oder mehrere aus der aus Si, Ge, Sn, O, S, Se, Be, V, Mg und Te bestehenden Gruppe ausgewählte(r) Dotierstoff(e), und/oder ein oder mehrere aus der aus Mn, Zn, Cr, Co, Ni, Cu und Fe bestehenden Gruppe ausgewählte(r) Dotierstoff(e). Daraus lassen sich je nach Wunsch und Bedarf III-N-Verbindungskristalle vom n-Typ, p-Typ und i-Typ in Masse (Bulk) sowie nach geeigneter Vereinzelung freistehende, dotierte III-N-Verbindungskristallsubstrate entsprechenden Typs herstellen. Si, Te, Mg und Fe werden als Dotierstoffe besonders bevorzugt. Der oder die verwendete(n) Dotierstoff(e) können zusammen als Mischung und insbesondere als Legierung mit mindestens einem Gruppe III-Material vorgelegt werden, oder die Mischung oder Legierung kann sich während des erfindungsgemäßen Verfahrens in situ beim Erzeugen der gemeinsamen Schmelze von Dotierstoff und Gruppe III-Material bilden.

Die III-N-Verbindung ist vorteilhaft einkristallin.

In bevorzugten Weiterbildungen der Erfindung erfolgt das epitaxiale Wachstum des dotierten III-N-Massivkristalls direkt auf einem Heterosubstrat (Fremdsubstrat) oder auf einem Homosubstrat (natürliches Substrat). Vor dem Wachstum des dotierten III-N-Massivkristalls können eine oder mehrere Zwischenschichten, vorzugsweise von III-N-Material, deren Zusammensetzung unabhängig von derjenigen des III-N-Massivkristalls gewählt werden kann, abgeschieden werden. Verfahren, Technik und/oder Vorrichtung zur Abscheidung der Zwischenschicht können frei gewählt werden.

In einer bevorzugten Weiterbildung der Erfindung wird als Substrat ein III-N-Substrat mit einer c-, a-, m- oder r-Ebene als Wachstumsebene verwendet, und der dotierte III-N-Massivkristall wird auf der ausgewählten Wachstumsebene abgeschieden.

In einer bevorzugten Weiterbildung der Erfindung wird als Substrat ein III-N-Substrat mit einer Wachstumsebene, die gegenüber einer c-, a-, m- oder r-Ebene eine Verkippung von 0.1 -30° aufweist, verwendet, und der dotierte III-N-Massivkristall wird darauf abgeschieden.

In einer bevorzugten Weiterbildung der Erfindung wird als Substrat einkristallines Saphir, Siliziumkarbid, Galliumarsenid, Lithiumaluminat oder Silizium verwendet, und darauf wird ein dotierter III-N-Massivkristall abgeschieden. In einer besonderes bevorzugten Weiterbildung wird als Substrat ein dotiertes oder undotiertes GaN-Substrat verwendet, und ein dotierter GaN-Massivkristall wird gezüchtet. Weiter bevorzugt entspricht die Dotierung des GaN-Substrates der Dotierung des darauf gezüchteten GaN-Massivkristalles.

In einer bevorzugten Weiterbildung der Erfindung besitzt der gezüchtete dotierte III-N-Massivkristall in der Ebene der Hauptoberfläche einen nahezu kreisförmigen Querschnitt, wobei bestimmte Strukturelemente wie Flats oder Notches optional stets möglich sind, und weist einen Durchmesser von ≥ 5cm auf. Die Länge des gezüchteten III-N-Massivkristalls beträgt ≥ 1mm, weiter bevorzugt ≥ 1cm und insbesondere ≥ 3cm oder mehr.

Es gehört zu den besonderen Vorteilen, dass mit der vorliegenden Erfindung eine einzigartige Homogenität der Dotierstoffkonzentration, insbesondere in der Wachstumsebene senkrecht zu der Wachstumsrichtung, bei diesen vorteilhaften Dimensionen des gezüchteten dotierten III-N-Massivkristalls und somit des daraus hergestellten vereinzelten, freistehenden III-N-Substrats bereitgestellt werden kann.

Nach Durchführung des erfindungsgemäßen Verfahrens können freistehende dotierte III-N-Kristallsubstrate hergestellt werden, indem ein oder mehrere III-N-Substrate von dem dotierten III-N-Massivkristall abgetrennt werden. Eine besonders geeignete Methode der Abtrennung ist das Drahtsägen. Anschließend können weitere Bearbeitungsschritte folgen, insbesondere zum Beispiel Läppen, Polieren, thermisches Nachbehandeln und/oder ein oder mehrere Endreinigungsschritte.

Weitere Variationen und Kombinationen der oben beschriebenen Gegenstände und Weiterbildungen der Erfindung sind ohne weiteres möglich.

Gemäß einer Weiterbildung des erfindungsgemäβen Verfahrens wird ein III-N-Massivkristall hergestellt. Zur Dotierung des erfindungsgemäßen III-N-Massivkristalls ist aktiv Dotierstoff in den III-N-Verbindungskristall eingebaut. Signifikante Parameter für die erfindungsgemäß realisierbare Homogenität des III-N-Massivkristalls und entsprechend des später noch beschriebenen, aus dem Massivkristall durch Vereinzelung erhältlichen, freistehenden dotierten III-N-Substrats sind, allein oder in Kombination, eine Homogenität der Ladungsträgerkonzentration, meßbar durch Frequenzlagen der LPP⁺-Mode beim Mikroraman-Mapping, eine Homogenität des spezifischen elektrischen Widerstands, meßbar durch Photoleitfähigkeitssignale beim MDP-Mapping, und eine Homogenität der Dotierstoffkonzentration, meßbar durch eine Linienbreite des D⁰X-Übergangs beim Mikro-Photolumineszenz-Mapping. Darüberhinaus zeichnen sich erfindungsgemäβ erhaltene III-N-Massivkristall und freistehendes dotiertes III-N-Substrat durch eine einzigartige Kombination eines oder mehrerer der genannten Homogenitätsparameter mit einer trotz der Dotierung sehr guten Kristallqualität, meßbar durch Halbwertsbreiten des charakteristischen E₂-Phonons, aus. Die genannten Parameter zu Homogenität und Kristallqualität werden nachfolgend näher beschrieben.

Die Materialparameter spezifischer elektrischer Widerstand und Ladungsträgerkonzentration sind von der Dotierstoffkonzentration abhängig. Der spezifische elektrische Widerstand wird üblicherweise mittels van-der-Pauw-Messungen oder Wirbelstrommessungen, die Ladungsträgerkonzentration mittels Hall-Messungen oder CV-Messungen ermittelt. Mit diesen Messmethoden ist zwar prinzipiell auch die Untersuchung der Verteilung der Dotierstoffkonzentration möglich, jedoch mitteln sie immer nur über den gemessenen Teil der Probe und ein Mapping mit vielen Messpunkten ist relativ wenig praktikabel. Die Ladungsträgerkonzentration kann jedoch auch bei Mikro-Ramanmessungen über die Position des höheren Zweigs der LO-Phonon-Plasmon gekoppelten Mode (LPP⁺) der E₁ Symmetrie bestimmt werden (Kasic et al., phys. stat. sol (a) 201 (2004) S. 2773; Yoon et al., Jpn. J. Appl. Phys. 44, S. 828). Die einzigartige Homogenität der Dotierstoffkonzentration des erfindungsgemäßen dotierten III-N-Massivkristalls und entsprechend der daraus abgetrennten, vereinzelten und freistehenden dotierten III-N-Substrate läßt sich daher insbesondere durch Mikro-Ramanmappings definieren.

So ist bei einem Mikro-Ramanmapping des erfindungsgemäßen III-N-Massivkristalls auf einer Fläche
(i) parallel zur Wachstumsebene und/oder
(ii) in Wachstumsrichtung
die Standardabweichung der jeweils gemessenen Ladungsträgerkonzentration, meßbar über die Frequenzlagen der LPP⁺-Mode,
im Fall (i) 5% oder weniger, vorzugsweise 3% oder weniger, weiter bevorzugt 2% oder weniger,
im Fall (ii) 10% oder weniger, vorzugsweise 7,5% oder weniger, weiter bevorzugt 5% oder weniger.

Die Standardabweichung kann ermittelt werden, indem bei einer Vielzahl, z.B. bei 100 Messpunkten der zu messenden Fläche (i) oder (ii) jeweils Mikro-Ramanmessungen durchgeführt werden, von allen Messungen der Mittelwert der Frequenzlagen der LPP⁺-Moden gebildet wird und gegenüber diesem Mittelwert über eine übliche statistische Auswertung die Standardabweichung ermittelt wird. Da im Fall (ii) das Heraustrennen einer Scheibenebene in Wachstumsrichtung des Massivkristalls wenig praktikabel ist, geht man zweckmäßig so vor, dass zunächst eine Vielzahl von Wafern jeweils mit einer Ebene, die senkrecht zur Wachstumsrichtung steht, aus dem Massivkristall abgetrennt werden, z.B. wie bei der üblichen Gewinnung von Wafern durch Drahtsägen entlang der Längsrichtung des Massivkristalls, dann wie oben erwähnt bei der Vielzahl, z.B. 100 Messpunkten, jeweils Mikro-Ramanmappings durchgeführt werden, und anschließend die Standardabweichung der Mittelwerte der jeweils auf den einzelnen Wafern bestimmten Frequenzlagen ermittelt wird. Wenn sich bei dieser Messung in Kontrollen mit einer Probe des Materials eine Abweichung von der zuvor erwähnten direkten Messung der Standardabweichung in Wachstumsrichtung ergibt, geht die direkte Messung in Wachstumsrichtung wegen der höheren Genauigkeit vor.

Eine Methode zum Nachweis der Homogenität des spezifischen elektrischen Widerstandes und damit auch der Dotierungskonzentration ist das Wafermapping mittels Mikrowellendetektierter Photoleitfähigkeitsmessungen (MDP) (J.R. Niklas et al. "GaAs Wafer Mapping by Microwave-detected Photoconductivity", Materials Science and Engineering B 80 (2001) 206). So ist, analog zum Raman-Mapping, die Standardabweichung des MDP-Signals bei einem Mapping auf einer Fläche parallel zur Wachstumsebene ein Maß für die Homogenität der Dotierungskonzentration in der Wachstumsebene. Die Homogenität senkrecht zur Wachstumsebene kann wiederum entweder durch ein Mapping auf einer Fläche, die die Wachstumsrichtung enthält, gewonnen werden oder durch die Standardabweichung der Mittelwerte, die aus den einzelnen aus einem Massivkristall gewonnenen Wafer bestimmt wurden, wobei die letztgenannte Methode praktikabler und damit bevorzugt ist. Bei Abweichungen geht wiederum die direkte Messung in Wachstumsrichtung wegen der höheren Genauigkeit vor. Beim MDP-Mapping können erfindungsgemäß Werte der Standardabweichungen der Photoleitfähigkeitssignale erreicht werden, die den oben zum Raman-Mapping beschriebenen entsprechen.

Eine weitere alternative Methode zum Nachweis der Homogenität der Dotierstoffkonzentration und damit der elektrischen Eigenschaften ist das Wafermapping mittels Mikro-Photolumineszenz-Messungen (Schubert et al., Appl. Phys. Lett. 71 pp 921 (1997)). Die Intensität und die Linienbreite des Übergangs der Donator-gebundenen Exzitonen (D⁰X) sind ein Maß für die Dotierstoffkonzentration. So ist, analog zu den bereits beschriebenen Messverfahren, die Standardabweichung der Photolumineszenz- D⁰X-Intensität und auch die Standardabweichung der Photolumineszenz- D⁰X-Linienbreite bei einem Mapping auf einer Fläche parallel zur Wachstumsebene ein Maß für die Homogenität der Dotierungskonzentration in der Wachstumsebene. Die Homogenität senkrecht zur Wachstumsebene kann wiederum entweder durch ein Mapping auf einer Fläche, die die Wachstumsrichtung enthält, gewonnen werden oder durch die Standardabweichung der Mittelwerte, die aus den einzelnen aus einem Massivkristall gewonnenen Wafer bestimmt wurden, wobei die letztgenannte Methode praktikabler und damit bevorzugt ist. Bei Abweichungen geht wiederum die direkte Messung in Wachstumsrichtung wegen der höheren Genauigkeit vor.

Beim Mikro-Photolumineszenz-Mapping können erfindungsgemäß Werte der Standardabweichungen der Linienbreite des D⁰X-Übergangs erreicht werden, die den oben zum Raman-Mapping beschriebenen entsprechen.

Die oben beschriebenen Homogenitätsparameter im erfindungsgemäß bereitgestellten, dotierten III-N-Bulkkristall können jeweils individuell realisiert werden, bevorzugt sind die Einzelparameter miteinander kombiniert.

Durch das Abtrennen aus hergestellten dotierten III-N-Massivkristallen sind einzelne, freistehende dotierte III-N-Substrate erhältlich, die eine entsprechende homogene Dotierung aufweisen.

Entsprechend wird erfindungsgemäß ein freistehendes dotiertes III-N-Substrat erhalten, bei dem bei einem Homogenitätsparameter, der aus der Gruppe der Homogenität der Ladungsträgerkonzentration, der Homogenität des spezifischen elektrischen Widerstands und der Homogenität der Dotierstoffkonzentration auswählbar ist,
auf einer Fläche
(i) parallel zur Wachstumsebene und/oder
(ii) in Wachstumsrichtung
die Standardabweichung der jeweils gemessenen Parameter, d.h. ausgewählt aus Frequenzlage der LPP⁺-Mode beim Mikro-Ramanmapping, Photoleitfähigkeitssignal beim MDP-Mapping und Linienbreite des D⁰X-Übergangs beim Mikro-Photolumineszenz-Mapping, im Fall (i) 5% oder weniger, bevorzugt 3% oder weniger und weiter bevorzugt 2% oder weniger,
im Fall (ii) 5% oder weniger, bevorzugt 3% oder weniger und weiter bevorzugt 2% oder weniger beträgt.

Darüber hinaus ermöglicht der homogene und gesteuerte Einbau des Dotierstoffs, dass erfindungsgemäß eine sehr gute Kristallqualität über die gesamte Wachstumsebene und im gesamten Bulkvolumen, also auch in Wachstumsrichtung erhalten wird.

Die Standardabweichungen von Frequenz und insbesondere die Halbwertsbreite des E₂-Phonons bei einem Scan auf einer Fläche parallel zur Wachstumsebene bzw. in Wachstumsrichtung Maße für die Homogenität der Kristallqualität parallel zur Wachstumsebene bzw. in Wachstumsrichtung. Die Homogenität der Kristallqualität des Bulkkristalls in Wachstumsrichtung kann wiederum vorzugsweise an Hand der Standardabweichung der Mittelwerte der Halbwertsbreiten des E₂-Phonons der einzelnen Substrate, die aus dem entsprechenden Bulkkristall gewonnen wurden, bestimmt werden. Die Halbwertsbreiten des E₂-Phonons können z.B. wie bei Kasic et al., phys. stat. sol (a) 201 (2004) pp. 2773 beschrieben über Mikro-Ramanmessungen bestimmt werden.

So beträgt bei dem erhaltenen III-N-Massekristall und beim anschlieβend erhaltenen freistehenden III-N-Substrat bei einem Mikro-Ramanmapping auf einer Fläche
(i) parallel zur Wachstumsebene und/oder
(ii) in Wachstumsrichtung
die Standardabweichung der gemessenen Halbwertsbreiten des E₂-Phonons aufgrund der ausgezeichneten Kristallqualität
im Fall (i) 5% oder weniger, bevorzugt 3% oder weniger, weiter bevorzugt 2% oder weniger, im Fall (ii) 5% oder weniger, weiter bevorzugt 3% oder weniger, weiter bevorzugt 2% oder weniger.

Bezüglich der Mikro-Ramanmapping-Messungen wird auf die obige Beschreibung verwiesen.

### Beschreibung von bevorzugten Ausführungsformen und von Ausführungsbeispielen

Im folgenden werden bevorzugte Ausführungsformen und Ausführungsbeispiele der Erfindung beschrieben, die jedoch nicht einschränkend zu verstehen sind. Vielmehr dienen sie lediglich der Erläuterung der Erfindung, und dem Fachmann werden Variationen und Modifikationen klar werden, die im Rahmen der beigefügten Ansprüche möglich sind.

In eine HVPE-Anlage wird dem Gruppe III-Material, hier z.B. Gallium in der Gallium-Quelle eine geringe Menge an Dotierstoff, z.B. hier Silizium beigegeben. Die Silizium-Konzentration liegt unterhalb 1%, also im leicht einstellbaren Löslichkeitsbereich von Si in Ga.. Als Start- oder Keimsubstrat wird ein Fremdsubstrat oder ein III-N-Substrat verwendet, wobei als mögliche Substratform auch ein sogenanntes Template eingeschlossen ist, bei dem auf einem Substrat eine oder mehrere Zwischenschichtmaterialien, jeweils unabhängig von Materialart und Abscheidungsmethode, abgeschieden ist. Vorzugsweise wird ein III-N-Substrat verwendet, beispielsweise ein GaN-Substrat mit einem Durchmesser > 5cm und einer (0001) Orientierung, weiter bevorzugt mit einer leichten Verkippung der Substratoberfläche gegen die exakte (0001) Ebene, beispielsweise um 0.3 oder 0.6 Grad.

Beim Aufheizen des Reaktors und der Gallium-Quelle löst sich das Silizium im Gallium. Die Temperatur der Quelle während des Wachstums liegt im Bereich 800 ° - 900 °C, somit wird das Silizium vollständig gelöst. Bereits vor Erreichen der Wachstumstemperatur (d.h. bei einer niedrigeren Temperatur) kann vorzugsweise eine Gasatmosphäre, die ein oder mehrere Gase, mindestens jedoch ein N-haltiges Gas, vorzugsweise mindestens die drei Gase Wasserstoff, Stickstoff und Ammoniak, zeitlich vorgelagert zugeschaltet werden. Insbesondere wird Ammoniakgas zur Stabilisierung der Oberfläche zugeschaltet. Nach Erreichen der Wachstumstemperatur wird das III-N-Massivkristallwachstum durch Zuschaltung des Chlorwasserstoff-Flusses über oder durch die Gallium-Quelle gestartet. Das bedeutet beispielsweise im Falle des GaN-Massivkristallwachstums, dass das Chlorwasserstoffgas mit der Gallium-Silizium-Mischung reagiert und dabei Galliumchlorid und Siliziumchlorid entstehen. Das Verhältnis von Galliumchlorid zu Siliziumchlorid kann auf Grund unterschiedlicher Reaktionskinetik vom Gallium-Silizium-Verhältnis in der Quelle abweichen, jedoch ist das Verhältnis in der Gasphase proportional zum Verhältnis in der_Schmelze. Galliumchorid und Siliziumchlorid werden dann zum Substrat geleitet, wo sie mit dem Ammoniak zu Siliziumdotiertem GaN reagieren. Die Silizium-Konzentration im Kristall kann also durch die Silizium-Konzentration in der Quelle gesteuert werden. Der Vorteil der erfindungsgemäßen Einbringung des Dotierstoffes liegt darin, dass während eines Wachstumsversuches immer dieselbe Konzentration des Dotierstoffes in den Kristall eingebaut wird, da die Konzentration von der Quelle vorgegeben ist. Darüber hinaus werden das Gallium und der Dotierstoff gemeinsam in nur einem Rohr zum Wachstumsbereich geführt, wodurch ein besonders homogener Einbau möglich wird. Würden hingegen bei herkömmlicher Dotierung die Dotierstoffe und das Gruppe-III-Material auf getrennten Wegen zum Wachstumsbereich gelangen, würden an der Wachstumsfront stets lokale Schwankungen auftreten und somit entsprechend das Verhältnis von Dotierstoff zu Gruppe III- und/oder zu N lokalen Schwankungen unterliegen.

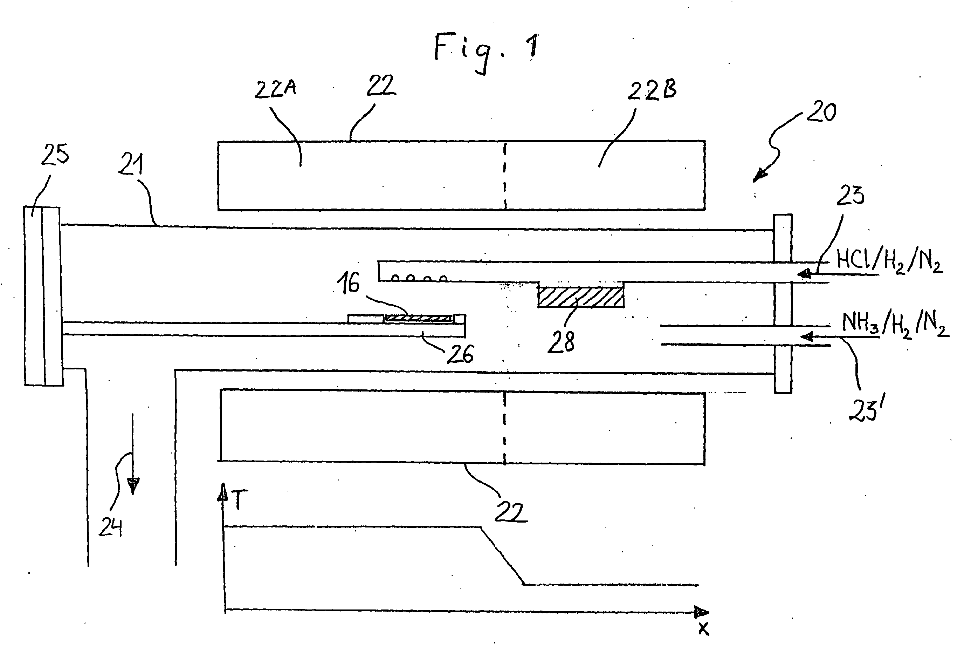

Fig. 1 zeigt schematisch ein Beispiel für einen grundsätzlichen Aufbau einer HVPE-Anlage im Querschnitt, auf die die vorliegende Erfindung anwendbar ist. Die HVPE-Anlage 20 schließt einen Glasreaktor 21, einen diesen umgebenden Mehrzonenofen 22, durch Pfeile angedeuteten Gasversorgungen 23, 23' und ein durch einen Pfeil angedeuteten Pump- und Abgasystem 24 ein. Das Template 16 wird auf einem Substrathalter 26 durch den Ent- und Beladeflansch 25 in den Reaktor 21 eingebracht. Mit dem Pump- und Abgassystem 24 wird der Reaktor danach auf den gewünschten Prozessdruck gebracht, geeigneterweise im Bereich von ≤ 1000mbar, zum Beispiel bei etwa 950 mbar. Der Mehrzonenofen besitzt eine erste Zone 22A, mit der die Wachstumstemperatur auf der Oberfläche des Substrats festgelegt wird und eine zweite Zone 22B, mit der die Temperatur im Bereich einer Ga-Wanne 28 festgelegt wird. Über die Gasversorgung 23, 23' wird H₂ und/oder N₂ als Trägergas in den Reaktor eingelassen. Zur Erzeugung von Galliumchlorid und Siliziumchlorid *in situ* wird das in der GaSi-Wanne vorliegende GaSi durch Einstellung einer geeigneten Temperatur in der Zone 22B des Mehrzonenofens 22, z.B. bei etwa 850°C, erhitzt und mit HCl, das aus der Gasversorgung 23 mit H₂/N₂-Trägergas in passendem Gasmischungsverhältnis und mit geeigneter Strömungsrate eingeströmt wird, umgesetzt. Die *in situ* erzeugte Mischung aus Galliumchlorid und Siliziumchlorid strömt gemeinsam aus Öffnungen am Ende des Einströmrohrs 23 in den Reaktor 21, und wird dort mit NH₃, das aus dem Einströmrohrs 23' mit einem H₂/N₂-Trägergasgemisch in passendem Gasmischungsverhältnis und mit geeigneter Strömungsrate zum Einstellen eines gewünschten NH₃-Partialdrucks von z.B. etwa 6 bis 7 · 10³ Pa eingeströmt wird, vermischt. Wie am Temperaturprofil in Fig. 1 unten erkennbar wird in der Zone 22A des Mehrzonenofens 22 eine relativ zur Zone 22B höhere Temperatur zur Einstellung einer Substrattemperatur von geeigneterweise etwa 950-1100°C, z.B. um 1050°C, eingestellt. Auf dem Substrathalter wird in diesem Beispiel Si-dotiertes GaN abgeschieden.

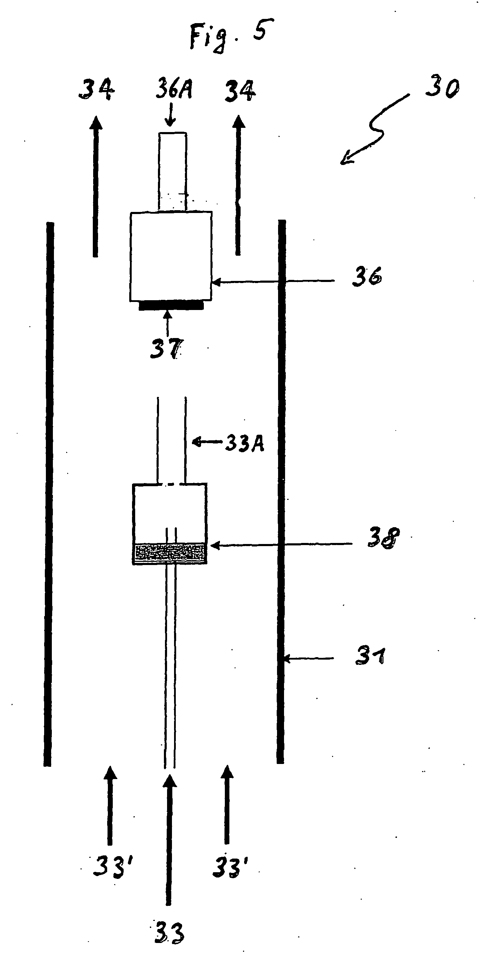

Fig. 5 zeigt schematisch ein Beispiel für einen grundsätzlichen Aufbau einer vertikalen HVPE-Anlage im Querschnitt, auf die die vorliegende Erfindung ebenfalls anwendbar ist. Der vertikale HVPE-Reaktors 30 weist Bestandteile auf, die dem horizontalen Aufbau der in fig. 1 gezeigten HVPE-Anlage 20 grundsätzlich entsprechen, einschießlich einer vertikalen Reaktorwand 31, einem Substrat oder einem Template 37, das an einem Suszeptor 36 gehalten wird und auf dem der III-N-Massekristall epitaxial gewachsen wird. Um die Reaktorwand 31 ist ein Ofen (nicht gezeigt), geeigneterweise ein Mehrzonenofen zum selektiven Erhitzen bestimmter vertikaler Bereiche des Reaktors, vorgesehen. Der Suszeptor 36 seinerseits ist an einer Suszeptorhalterung 36A befestigt. Eine Gasstromzufuhrrohr 33 leitet zunächst HCl und Trägergase (z.B. H₂ und N₂) in einen Behältnis der Quelle 38 geleitet, in dem das Gruppe III-Material Gallium in Mischung mit dem Dotierstoff Si vorgelegt sind. Die Mischung der Reaktionsgase, die Galliumchlorid und Siliziumchlorid enthalten, werden anschließend über das weitere Zufuhrrohr 33A in den Reaktor geleitet. Eine Gasstromzuführung für NH₃ und Trägergase (z.B. H₂ und N₂, s. die beiden äußeren Pfeile 33' unten) sorgt für ein Einströmen des N-Bestandteils des III-N-Kristalls. Ein Gasstromauslaß (s. die äußeren Pfeile 34 oben) leitet Abgase ab.

Es können beliebige Modifikationen und Variationen sowohl am horizontalen als auch am vertikalen Aufbau einer HVPE-Anlage, wie sie jeweils in den Fig. 1 und 5 gezeigt sind, durchgeführt werden.

Falls anstelle von Silizium ein anderer Dotierstoff, wie beispielsweise Te, Fe, Mg oder Zn oder eine Mischung solcher Dotierstoffe, gewählt wird, so wird dieser anstelle des Siliziums dem Gallium zugegeben. Falls anstelle einer dotierten GaN-Schicht z.B. eine dotierte (Ga,Al,In)N-, (Ga,Al)N- oder (Ga,In)N-Schicht abgeschieden werden soll, ist/sind in der HVPE-Anlage 20 oder 30 zusätzliche Al- und/oder In-Wannen bzw. -Behälter und entsprechende Einströmrohre vorgesehen (in Fig. 1 und 5 nicht gezeigt). Die Einbringung des Dotierstoffes kann dann je nach Löslichkeit in den Gruppe-III-Elementen in einem oder in verschiedenen III-Quellen geschehen. Die Einströmung von entsprechenden Aluminium- und/oder Indiumchlorid in den Reaktor erfolgt beispielsweise durch Zustrom von HCl in geeignetem Trägergas von z.B. H₂/N₂, analog wie in Fig. 1 mit dem Einströmrohr 23 oder wie in Fig. 5 mit dem Einströmrohrsystem 33/33A für Ga gezeigt.

Dicke dotierte Schichten mit einem Dickenbereich von 1 mm oder darüber, vorzugsweise bis 30000 µm oder darüber, können auf diese Weise effizient und mit sehr guter Homogenität der Dotierung erhalten werden.

Der gezüchtete dotierte III-N-Massivkristall wird, üblicherweise nach einem oder mehreren Prozessschritt(en) wie beispielsweise Rundschleifen und Orientieren, vorzugsweise durch Drahtsägen vereinzelt. Dotierte III-N-Substrate erhält man geeigneterweise nach weiteren Prozessschritten, wie beispielsweise, Läppen, Polieren, Kantenverrunden, Schleifen von Flats oder Notches, thermisches Ausheilen sowie verschiedenen Endreinigungsschritten. Dabei sind Läpp- und Polierschritte in der Regel mehrstufige Prozesse.

Die gezüchteten dotierten III-N-Massivkristalle wie auch die durch die nachfolgenden Prozessschritte erhaltenen III-N-Substrate zeigen nun auf Grund der beschriebenen Einbringung des Dotierstoffes eine ausgezeichnet homogene Verteilung des Dotierstoffes in Wachstumsrichtung bzw. auch in der Ebene senkrecht dazu.

Messtechnisch erfassen lässt sich dies beispielsweise mittels Mikro-Ramanmessungen. So ist beispielsweise die Standardabweichungen der Frequenz der LPP⁺-Mode bei einem Scan auf einer Fläche parallel zur Wachstumsebene bzw. in Wachstumsrichtung ein Maß für die Homogenität der Dotierung parallel zur Wachstumsebene bzw. in Wachstumsrichtung. Die Homogenität der Dotierung des Massivkristalls in Wachstumsrichtung kann wiederum vorzugsweise an Hand der Standardabweichung der Mittelwerte der Frequenzen der LPP⁺-Mode der einzelnen Substrate, die aus dem entsprechenden Massivkristall gewonnen wurden, bestimmt werden.

In einem speziellen Ausführungsbeispiel wird ein GaN-Substrat mit einem Durchmesser zwischen 50 und 60mm in einen Aixtron LP-HVPE-Reaktor transferiert. Die Gruppe-III-Quelle wird mit Gallium bestückt, welchem 0,1% Silizium zugegeben werden. Auf dem Substrat wird ein massiver dotierter GaN-Kristall mit einer Dicke von mehreren mm aufgewachsen. Der HVPE-Prozess findet zum Beispiel bei einer Temperatur von 1040°C bis 1075°C und bei einem Druck von 900 bis 1000 mbar mit einem V/III-Verhältnis von etwa 50 und einer Trägergaszusammensetzung von etwa 50% Wasserstoff und 50% Stickstoff statt. Die Wachstumsrate beträgt ∼ 220µm/h und kann mit Hilfe des Chlorwasserstoffgasflusses durch/über die Ga-Quelle gesteuert werden.

Die Mikro-Ramanmessungen werden mit einer Laseranregungswellenlänge von 532 nm (Frequenzverdoppelter Nd:YAG-Laser), einer Anregungsleistung von 3 mW sowie mit einem Labram800HR Spektrometer von Jobin Yvon durchgeführt, wobei die Laserlinie mit Hilfe einer Mikroskopoptik auf einen Strahldurchmesser von ∼ 1 µm auf der Probe fokussiert wird. Das Spektrometer wird zusätzlich mit Hilfe von Ne-Plasmalinien kalibriert. Die Messungen werden in Rückstreugeometrie durchgeführt, wobei die Polarisatorstellungen derart gewählt werden, daß die LPP⁺-Mode detektiert werden kann. Bei dem Scan auf der Oberfläche beträgt die Schrittweite in x- und y-Richtung ∼2,5mm. Der Randausschlussbereich beträgt 2mm vom Waferrand. Bei dem Scan auf der senkrecht zur Oberfläche liegenden Spaltfläche des Wafers beträgt die Schrittweite in z-Richtung ∼10µm. Frequenz und Halbwertsbreite des E₂-Phonons und der LPP⁺-Mode werden durch Lorentz-Linienformanalysen bestimmt.

Die Messungen werden ferner in Rückstreugeometrie so durchgeführt, daß die Polarisatorstellungen derart gewählt werden, daß die E₂-Phonon detektiert werden können [Scan auf Oberfläche: z(y x/y)-z; Scan auf Spaltfläche: y(x x)-y]. Frequenz und Halbwertsbreite des E₂-Phonons werden durch Lorentz-Linienformanalysen bestimmt.

Die MDP-Messungen werden mit einer Laseranregungswellenlänge von 351 nm sowie mit einem Strahldurchmesser von ∼ 50µm durchgeführt. Das Photoleitfähigkeitssignal wird mit Hilfe eines Mikrowellen-Spektrometers/Resonators durch die Beeinflussung des Absorptionsverhaltens im Mikrowellenbereich generiert. Dabei wird der Laser mit ∼ 1,5kHz periodisch unterbrochen und das Signal mit konventioneller Lock-In-Technik detektiert. Bei dem Scan auf der Oberfläche beträgt die Schrittweite in x- und y-Richtung ∼2,5mm. Der Randausschlussbereich beträgt 2mm vom Waferrand.

Die Mikro-Photolumineszenz-Messungen werden bei Raumtemperatur (293 K) durchgerührt. Die Anregungsleistung liefert ein HeCd-Laser mit einer Emissionswellenlänge von 325nm. Die Dichte der Anregungsleistung beträgt 3 W/cm² (Schubert et al., Appl. Phys. Lett. 71 pp 921 (1997)). Bei dem Scan auf der Oberfläche beträgt die Schrittweite in x- und y-Richtung ∼2,5mm. Der Randausschlussbereich beträgt 2mm vom Waferrand.

## Patentansprüche

1. Verfahren zum Herstellen einer dotierten kristallinen III-N-Schicht oder eines dotierten III-N-Massivkristalls, wobei III mindestens ein Element der III. Hauptgruppe des Periodensystems, ausgewählt aus Al, Ga und In, bedeutet, mit den Schritten:
Bereitstellen einer Mischung eines Dotierstoffs in elementarer Form und eines Gruppe-III-Ausgangsmaterials in elementarer Form in einer III-Quelle,
Bringen von Spezies des Dotierstoffs und des III-Materials gemeinsam in die Gasphase und gemeinsames Zuführen zu einem Reaktor oder einem Wachstumsbereich, wobei im Fall der Verwendung mehrerer III-Elemente die verschiedenen III-Elemente aus verschiedenen III-Quellen zugeführt werden, und
Abscheiden der dotierten kristallinen III-N-Schicht oder des dotierten III-N-Massivkristalls auf einem Substrat oder Template in dem Reaktor mittels Hydridgasphasenepitaxie bei einer Wachstumsrate von etwa 200 bis etwa 1000 µm/h.

2. Verfahren gemäß Anspruch 1, wobei zusätzlich zu der gemeinsamen Zufuhr und getrennt davon
- eine weitere Zufuhr von Dotierstoff allein oder mit demselben oder einem anderen Gruppe III-Material, oder
- eine weitere Zufuhr von demselben oder einem anderen Gruppe III-Material durchgeführt wird.

3. Verfahren gemäß einem der vorangehenden Ansprüche, wobei in einem Reaktor für Hydridgasphasenepitaxie (HVPE)
- eine gemeinsame Quelle für das Gruppe III-Ausgangsmaterial und das Dotiermittel bereitgestellt wird und ein Halogenid-Reaktionsgas in die bzw. zu der gemeinsame(n) Quelle so eingeführt wird, daß eine Mischung von Halogeniden des Gruppe III-Ausgangsmaterials und des Dotierstoffs gebildet wird und die Mischung einem Wachstumsbereich des HVPE-Reaktors zugeführt wird, wobei im Fall der Verwendung mehrerer III-Elemente die verschiedenen III-Elemente in verschiedenen III-Quellen bereitgestellt werden, und
- ein N-Ausgangsmaterial in den HVPE-Reaktor eingeführt wird,
wodurch die dotierte kristalline III-N-Schicht oder der dotierte III-N-Massivkristall mit einem homogenen Einbau des Dotierstoffs in den III-N-Kristall gebildet wird.

4. Verfahren gemäß einem der vorangehenden Ansprüche, umfassend folgende Schritte:
- Bereitstellen einer festen Lösung, einer Legierung oder einer gemischten Schmelze in einer III-Quelle, jeweils das Element der III. Hauptgruppe des Periodensystems und das Element des Dotierstoffs für das III-N-Material der kristallinen III-N-Schicht oder des dotierten III-N-Massivkristalls umfassend, wobei im Fall der Verwendung mehrerer III-Elemente die verschiedenen III-Elemente in verschiedenen III-Quellen bereitgestellt werden,
- Kontaktieren der bereitgestellten festen Lösung, Legierung oder gemischten Schmelze mit einem Reaktionsgas zur Bildung von gemischten Produkten aus dem Gruppe III-Element und dem Dotierstoff jeweils mit einem Bestandteil des Reaktionsgases in Gasphase, und
- Kontaktieren der so gebildeten gemischten Produkte mit einem N-Ausgangsmaterial in Gasphase, und
- Abscheiden von kristalliner III-N-Schicht oder von III-N-Massivkristall jeweils mit eingebautem Dotierstoff.

5. Verfahren gemäß einem der vorangehenden Ansprüche, wobei vor Züchtung der kristallinen III-N-Schicht oder des dotierten III-N-Massivkristalls eine oder mehrere Zwischenschichten, deren Zusammensetzung unabhängig von derjenigen der dotierten III-N-Schicht oder des dotierten III-N-Massivkristalls gewählt wird, abgeschieden wird (werden).

6. Verfahren nach einem der vorangehenden Ansprüche, wobei als Dotierstoff jeweils ein Element verwendet wird, das ausgewählt wird aus der Gruppe, die aus Silizium, Tellur, Magnesium, Eisen, Germanium, Zinn, Selen, Beryllium, Vanadium, Mangan, Zink, Chrom, Nickel und Kupfer besteht, wobei der Dotierstoff vorzugsweise aus der aus Si, Te, Mg, Mn und Fe bestehenden Gruppe ausgewählt wird und insbesondere Si ist.

7. Verfahren nach einem der vorangehenden Ansprüche, wobei die dotierte kristalline III-N-Schicht oder der dotierte III-N-Massivkristall einen nahezu kreisförmigen Querschnitt besitzt und die Durchmesser des Substrats bzw. Templates und der kristallinen III-N-Schicht oder des III-N-Massivkristalls jeweils ≥ 5cm betragen.

8. Verfahren nach einem der vorangehenden Ansprüche, wobei die Länge des dotierten gezüchteten III-N-Massivkristalls ≥ 0.1 mm, vorzugsweise ≥ 1mm, weiter bevorzugt ≥ 1cm und insbesondere ≥ 3cm beträgt.

9. Verfahren nach einem der vorstehenden Ansprüche, wobei als Substrat ein dotiertes oder undotiertes GaN-Substrat oder als Template ein mit GaN beschichtetes Fremdsubstrat verwendet und ein dotierter GaN-Massivkristall gezüchtet wird.

10. Verfahren nach einem der vorangehenden Ansprüche, wobei die hergestellte dotierte kristalline III-N-Schicht oder der hergestellte dotierter III-N-Massivkristall einen Homogenitätsparameter aufweist, der aus einem der folgenden Parameter (a) bis (c) ausgewählt ist:
(a) bei einem Mikro-Ramanmapping auf einer Fläche
(i) parallel zur Wachstumsebene und/oder
(ii) in Wachstumsrichtung
beträgt die Standardabweichung der gemessenen Frequenzlagen der LPP⁺-Mode im Fall (i) 5% oder weniger,
im Fall (ii) 10% oder weniger;
(b) bei einem MDP-Mapping auf einer Fläche
(i) parallel zur Wachstumsebene und/oder
(ii) in Wachstumsrichtung
beträgt die Standardabweichung der Photoleitfähigkeitssignale
im Fall (i) 5% oder weniger,
im Fall (ii) 10% oder weniger;
(c) bei einem Mikro-Photolumineszenz-Mapping auf einer Fläche
(i) parallel zur Wachstumsebene und/oder
(ii) in Wachstumsrichtung
beträgt die Standardabweichung der Linienbreite des D⁰X-Übergangs
im Fall (i) 5% oder weniger,
im Fall (ii) 10% oder weniger.

11. Verfahren gemäß Anspruch 10, wobei die hergestellte dotierte kristalline III-N-Schicht oder der hergestellte dotierter III-N-Massivkristall bei einem Mikro-Ramanmapping auf einer Fläche
(i) parallel zur Wachstumsebene und/oder
(ii) in Wachstumsrichtung
die Standardabweichung der gemessenen Halbwertsbreiten des E₂-Phonons im Fall (i) 5% oder weniger,
im Fall (ii) 5% oder weniger
beträgt.

12. Verfahren zum Herstellen eines freistehenden dotierten III-N-Kristallsubstrats, wobei III mindestens ein Element der III. Hauptgruppe des Periodensystems, ausgewählt aus Al, Ga und In, bedeutet, mit den Schritten:
a) Durchführung des Verfahrens nach einem der Ansprüche 1 bis 9, und
b) Abtrennen eines oder mehrerer dotierter III-N-Substrate.

13. Verfahren gemäß Anspruch 12, wobei das freistehende dotierte III-N-Substrat einen Homogenitätsparameter aufweist, der aus einem der folgenden Parameter (a) bis (c) ausgewählt ist:
(a) bei einem Mikro-Ramanmapping auf einer Fläche
(i) parallel zur Wachstumsebene und/oder
(ii) in Wachstumsrichtung
beträgt die Standardabweichung der gemessenen Frequenzlagen der LPP⁺-Mode im Fall (i) 5% oder weniger
im Fall (ii) 5% oder weniger;
(b) bei einem MDP-Mapping auf einer Fläche
(i) parallel zur Wachstumsebene und/oder
(ii) in Wachstumsrichtung
die Standardabweichung der Photoleitfähigkeitssignale
im Fall (i) 5% oder weniger
im Fall (ii) 5% oder weniger;
(c) bei einem Mikro-Photolumineszenz-Mapping auf einer Fläche
(i) parallel zur Wachstumsebene und/oder
(ii) in Wachstumsrichtung
beträgt die Standardabweichung der Linienbreite des D⁰X-Übergangs im Fall (i) 5% oder weniger
im Fall (ii) 5% oder weniger.

14. Verfahren gemäß Anspruch 14, wobei bei einem Mikro-Ramanmapping des freistehenden dotierten III-N-Substrats auf einer Fläche
(i) parallel zur Wachstumsebene und/oder
(ii) in Wachstumsrichtung
die Standardabweichung der gemessenen Halbwertsbreiten des E₂-Phonons im Fall (i) 5% oder weniger,
im Fall (ii) 5% oder weniger
beträgt.

## Claims

1. A process for producing a doped crystalline III-N layer or a doped III-N bulk crystal, wherein III denotes at least one element of the main group III of the periodic table of the elements, selected from Al, Ga and In, the process comprising the steps:
providing a mixture of a dopant in elemental form and a group III starting material in elemental form in a III source,
bringing species of the dopant and the III material together into the gas phase and feeding together to a reactor or a growth region, wherein in the case of using multiple III elements the different III elements are fed from different III sources, and
depositing the doped crystalline III-N layer or the doped III-N bulk crystal on a substrate or template in the reactor by means of hydride vapor phase epitaxy at a growth rate from approximately 200 to approximately 1000 µm/h.

2. The process according to claim 1, wherein in addition to the feeding together and separately therefrom,
- a further feeding of dopant alone or with the same or another group III material, or
- a further feeding of the same or another group III material
is carried out.

3. The process according to claim 1 or 2, wherein in a reactor for hydride vapor phase epitaxy (HVPE)
- a common source for the group III starting material and the dopant is provided, and a halide reaction gas is fed into or respectively to the common source such that a mixture of halides of the group III starting material and the dopant is formed, and the mixture is fed to a growth region of the HVPE reactor, wherein in the case of using multiple III elements the different III elements are provided in different III sources, and
- an N starting material is fed into the HVPE reactor, whereby the doped crystalline III-N layer or the doped III-N bulk crystal is formed with a homogenous incorporation of the dopant into the III-N crystal.

4. The process according to any one of the preceding claims, comprising the following steps:
- providing a solid solution, an alloy or a mixed melt in a III source, respectively comprising the element of the main group III of the periodic table of the elements and the element of the dopant for the III-N material of the crystalline III-N layer or the doped III-N bulk crystal, wherein in the case of using multiple III elements the different III elements are provided in different III sources,
- contacting the provided solid solution, alloy or mixed melt with a reaction gas for the formation of mixed products of the group III element and the dopant respectively with a component of the reaction gas in vapor phase, and
- contacting the thus formed mixed products with an N starting material in vapor phase, and
- depositing crystalline III-N layer or III-N bulk crystal respectively with dopant being incorporated.

5. The process according to any one of the preceding claims, wherein in advance of growing the crystalline III-N layer or the doped III-N bulk crystal one or multiple intermediate layer(s) is (are) deposited, the composition of which is chosen independently from that of the doped III-N layer or the doped III-N bulk crystal.

6. The process according to any one of the preceding claims, wherein as dopant respectively an element is used which is selected from the group consisting of silicon, tellurium, magnesium, iron, germanium, tin, selenium, beryllium, vanadium, manganese, zinc, chromium, nickel and copper, wherein the dopant is preferably selected from the group consisting of silicon, tellurium, magnesium, manganese and iron and in particular is silicon.

7. The process according to any one of the preceding claims, wherein the doped crystalline III-N layer or the doped III-N bulk crystal has an almost circular cross-section and the diameters of the substrate or respectively template and of the crystalline III-N layer or the III-N bulk crystal are ≥ 5 cm, respectively.

8. The process according to any one of the preceding claims, wherein the length of the doped grown III-N bulk crystal is ≥ 0.1 mm, preferably is ≥ 1 mm, more preferably is ≥ 1 cm and in particular is ≥ 3 cm.

9. The process according to any one of the preceding claims, wherein as substrate a doped or undoped GaN substrate or as template a foreign substrate coated with GaN is used and a doped GaN bulk crystal is grown.

10. The process according to any one of the preceding claims, wherein the produced doped crystalline III-N layer or the produced doped III-N bulk crystal has a homogeneity parameter, selected from one of the following parameters (a) to (c) :
(a) in a micro-Raman mapping on a plane
(i) parallel to the growth plane and/or
(ii) in the growth direction
the standard deviation of the measured frequency positions of the LPP⁺ mode
in the case of (i) is 5% or less,
in the case of (ii) is 10% or less;
(b) in a microwave-detected photoconductivity (MDP) mapping on a plane
(i) parallel to the growth plane and/or
(ii) in the growth direction
the standard deviation of the photoconductivity signals in the case of (i) is 5% or less,
in the case of (ii) is 10% or less;
(c) in a micro-photoluminescence mapping on a plane
(i) parallel to the growth plane and/or
(ii) in the growth direction
the standard deviation of the line width of the D⁰X transition
in the case of (i) is 5% or less,
in the case of (ii) is 10% or less.

11. The process according to claim 10, wherein the produced doped crystalline III-N layer or the produced doped III-N bulk crystal in a micro-Raman mapping on a plane
(i) parallel to the growth plane and/or
(ii) in the growth direction
has a standard deviation of the measured full widths at half maximum of the E₂ phonon
of 5% or less in the case of (i),
of 5% or less in the case of (ii).

12. A process for producing a free-standing doped III-N crystal substrate, wherein III denotes at least one element of the main group III of the periodic table of the elements selected from Al, Ga and In, comprising the steps:
a) carrying out the process according to any one of the claims 1 to 9, and
b) separating one or multiple doped III-N substrate(s).

13. The process according to claim 12, wherein the free-standing doped III-N substrate has a homogeneity parameter, selected from one of the following parameters (a) to (c):
(a) in a micro-Raman mapping on a plane
(i) parallel to the growth plane and/or
(ii) in the growth direction
the standard deviation of the measured frequency positions of the LPP⁺ mode
in the case of (i) is 5% or less,
in the case of (ii) is 5% or less;
(b) in a microwave-detected photoconductivity (MDP) mapping on a plane
(i) parallel to the growth plane and/or
(ii) in the growth direction
the standard deviation of the photoconductivity signals in the case of (i) is 5% or less,
in the case of (ii) is 5% or less;
(c) in a micro-photoluminescence mapping on a plane
(i) parallel to the growth plane and/or
(ii) in the growth direction
the standard deviation of the line width of the D⁰X transition
in the case of (i) is 5% or less,
in the case of (ii) is 5% or less.

14. The process according to claim 13, wherein in a micro-Raman mapping of the free-standing doped III-N substrate on a plane
(i) parallel to the growth plane and/or
(ii) in the growth direction
the standard deviation of the measured full widths at half maximum of the E₂ phonon
in the case of (i) is 5% or less,
in the case of (ii) is 5% or less.

## Revendications

1. Procédé de fabrication d'une couche cristalline III-N dopée ou d'un cristal massif III-N dopé, où III représente au moins un élément du groupe principal III de la classification périodique sélectionné parmi Al, Ga et In, comprenant les étapes suivantes :
préparation d'un mélange d'une substance dopante sous une forme élémentaire et d'un matériau initial du groupe III sous une forme élémentaire dans une source III,
amenée commune de variétés de la substance dopante et du matériau du groupe III en phase gazeuse et conduction commune vers un réacteur ou une zone de croissance, les différents éléments III étant conduits depuis différentes sources III, en cas d'utilisation de plusieurs éléments III, et
séparation de la couche cristalline III-N dopée ou du cristal massif III-N dopé sur un substrat ou un gabarit dans le réacteur, par épitaxie en phase gazeuse hybride, pour un taux de croissance de quelque 200 à quelque 1000 µm/h.

2. Procédé selon la revendication 1, dans lequel, en complément de la conduction commune et séparément de celle-ci, il est procédé à
- une autre conduction de substance dopante, seule, ou avec le même matériau, ou avec un autre matériau du groupe III, ou à
- une autre conduction du même matériau, ou d'un autre matériau du groupe III.

3. Procédé selon l'une des revendications précédentes, dans lequel, dans un réacteur pour épitaxie en phase gazeuse hybride (HVPE)
- une source commune est préparée pour le matériau initial du groupe III et la substance dopante et un gaz haloïde réactif est introduit dans la, ou est ajouté à la source commune de manière à former un mélange d'halogénures du matériau initial du groupe III et de la substance dopante, ledit mélange étant conduit vers une zone de croissance du réacteur HVPE, et les différents éléments III étant préparés dans différentes sources III, en cas d'utilisation de plusieurs éléments III, et
- un matériau initial N est introduit dans le réacteur HVPE, la couche cristalline III-N dopée ou le cristal massif III-N dopé étant ainsi formés avec une incorporation homogène de la substance dopante dans le cristal III-N.

4. Procédé selon l'une des revendications précédentes, comprenant les étapes suivantes :
- préparation d'une solution solide, d'un alliage ou d'une fonte mixte dans une source III, comportant élément du groupe principal III de la classification périodique et l'élément de la substance dopante pour le matériau III-N de la couche cristalline III-N ou du cristal massif III-N dopé, les différents éléments III étant préparés dans différentes sources III, en cas d'utilisation de plusieurs éléments III,
- mise en contact de la solution solide, de l'alliage ou de la fonte mixte ainsi préparés avec un gaz réactif pour former des produits de mélange à partir de l'élément du groupe III et de la substance dopante avec un composant du gaz réactif en phase gazeuse, et
- mise en contact des produits de mélange ainsi formés avec un matériau initial N en phase gazeuse, et
- séparation de la couche cristalline III-N ou du cristal massif III-N avec la substance dopante incorporée.

5. Procédé selon l'une des revendications précédentes, dans lequel, préalablement à la croissance de la couche cristalline III-N ou du cristal massif III-N dopé, il est procédé à la séparation d'une ou de plusieurs couches intercalaires, dont la composition est sélectionnée indépendamment de celle de la couche cristalline III-N dopée ou du cristal massif III-N dopé.

6. Procédé selon l'une des revendications précédentes, dans lequel un élément est utilisé comme substance dopante, lequel est sélectionné dans le groupe composé de silicium, tellure, magnésium, fer, germanium, étain, sélénium, béryllium, vanadium, manganèse, zinc, chrome, nickel et cuivre, la substance dopante étant préférentiellement sélectionnée dans le groupe composé de Si, Te, Mg, Mn et Fe, et étant en particulier du Si.

7. Procédé selon l'une des revendications précédentes, dans lequel la couche cristalline III-N dopée ou le cristal massif III-N dopé présentent une section transversale sensiblement circulaire, et le diamètre du substrat ou du gabarit et de la couche cristalline III-N dopée ou du cristal massif III-N dopé est supérieur ou égal à 5 cm.

8. Procédé selon l'une des revendications précédentes, dans lequel la longueur du cristal massif III-N dopé soumis à croissance cristalline est supérieure ou égale à 0,1 mm, de préférence supérieure ou égale à 1 mm, notamment supérieure ou égale à 1 cm, et tout particulièrement supérieure ou égale à 3 cm.

9. Procédé selon l'une des revendications précédentes, dans lequel un substrat GaN dopé ou non dopé est utilisé comme substrat, ou bien un substrat étranger revêtu de GaN est utilisé comme gabarit, et un cristal massif GaN dopé est soumis à croissance cristalline.

10. Procédé selon l'une des revendications précédentes, dans lequel la couche cristalline III-N dopée produite ou le cristal massif III-N dopé produit présentent un paramètre d'homogénéité sélectionné parmi les paramètres (a) à (c) suivants :
a) pour une micro-spectroscopie Raman sur une surface
(i) parallèlement au plan de croissance et/ou
(ii) dans la direction de croissance,
l'écart standard des positions en fréquence mesurées du mode LPP⁺ est inférieur ou égal à 5 % dans le cas (i),
inférieur ou égal à 10 % dans le cas (ii),
b) pour une spectroscopie MDP sur une surface
(i) parallèlement au plan de croissance et/ou
(ii) dans la direction de croissance,
l'écart standard des signaux de photoconductivité est inférieur ou égal à 5 % dans le cas (i),
inférieur ou égal à 10 % dans le cas (ii),
c) pour une micro-spectroscopie par photoluminescence sur une surface
(i) parallèlement au plan de croissance et/ou
(ii) dans la direction de croissance,
l'écart standard de la largeur de raie de la transition D⁰X est inférieur ou égal à 5 % dans le cas (i),
inférieur ou égal à 10 % dans le cas (ii).

11. Procédé selon la revendication 10, dans lequel, pour une micro-spectroscopie Raman de la couche cristalline III-N dopée produite ou du cristal massif III-N dopé produit, sur une surface
(i) parallèlement au plan de croissance et/ou
(ii) dans la direction de croissance,
l'écart standard des largeurs de valeur moyenne du phonon E₂ est inférieur ou égal à 5 % dans le cas (i),
inférieur ou égal à 5 % dans le cas (ii).

12. Procédé de fabrication d'un substrat cristallin III-N dopé isolé, dans lequel III représente au moins un élément du groupe principal III de la classification périodique sélectionné parmi Al, Ga et In, comprenant les étapes suivantes :
a) exécution du procédé selon l'une des revendications 1 à 9, et
b) séparation d'un ou de plusieurs substrats III-N dopés.

13. Procédé selon la revendication 12, dans lequel le substrat III-N dopé isolé présente un paramètre d'homogénéité sélectionné parmi les paramètres (a) à (c) suivants :
a) pour une micro-spectroscopie Raman sur une surface
(i) parallèlement au plan de croissance et/ou
(ii) dans la direction de croissance,
l'écart standard des positions en fréquence mesurées du mode LPP⁺ est inférieur ou égal à 5 % dans le cas (i),
inférieur ou égal à 5 % dans le cas (ii),
b) pour une spectroscopie MDP sur une surface
(i) parallèlement au plan de croissance et/ou
(ii) dans la direction de croissance,
l'écart standard des signaux de photoconductivité est inférieur ou égal à 5 % dans le cas (i),
inférieur ou égal à 5 % dans le cas (ii),
c) pour une micro-spectroscopie par photoluminescence sur une surface
(i) parallèlement au plan de croissance et/ou
(ii) dans la direction de croissance,
l'écart standard de la largeur de raie de la transition D⁰X est inférieur ou égal à 5 % dans le cas (i),
inférieur ou égal à 5 % dans le cas (ii).

14. Procédé selon la revendication 13, dans lequel, pour une micro-spectroscopie Raman du substrat III-N dopé isolé sur une surface
(i) parallèlement au plan de croissance et/ou
(ii) dans la direction de croissance,
l'écart standard des largeurs de valeur moyenne du phonon E₂ est inférieur ou égal à 5 % dans le cas (i),
inférieur ou égal à 5 % dans le cas (ii).
